# FASCICULE DE BREVET EUROPEEN

(11) **EP 1 336 857 B1**
(45) Date de publication et mention de la délivrance du brevet: **18.08.2010**
(21) Numéro de dépôt: 03290317.1
(22) Date de dépôt: 07.02.2003
(51) Int. Cl.: G01R 31/36

(54) **Système de détermination de l'état de charge d'une batterie, notamment pour véhicule automobile**
Anordnung zur Bestimmung des Ladezustands einer Batterie, insbesondere zur Verwendung in einem Kraftfahrzeug
System for determining the state of charge of a battery, especially for a motor vehicle

(30) Priorité: 13.02.2002 FR 0201780
(43) Date de publication de la demande: 20.08.2003
(73) Titulaire: Peugeot Citroën Automobiles SA, 78943 Vélizy-Villacoublay Cedex (FR)
(72) Inventeur: Thauvin, Nicolas, 78000 Versailles (FR); Colledani, Frédéric, 92000 Nanterre (FR)
(74) Mandataire: Ménès, Catherine

(56) Documents cités:
- EP-A- 1 049 231
- US-A- 4 390 841
- US-A- 5 698 965
- US-B1- 6 252 377
- US-B1- 6 285 163
- PATENT ABSTRACTS OF JAPAN vol. 013, no. 586 (P-982), 25 décembre 1989 (1989-12-25) & JP 01 250080 A (SHIN KOBE ELECTRIC MACH CO LTD), 5 octobre 1989 (1989-10-05)

## Description

La présente invention concerne un système de détermination de l'état de charge d'une batterie de stockage d'énergie électrique, notamment pour véhicule automobile.

L'état de charge d'une batterie par exemple de traction d'un véhicule hybride ou d'un véhicule électrique, donne une idée de la capacité de la batterie, mesurée en Ampère-heure.

Cependant, il n'existe pas de capteur donnant une mesure de cet état de charge de batterie.

Il faut donc se baser sur une estimation de celui-ci, cette estimation étant obtenue à partir de mesures de grandeurs caractéristiques de cette batterie.

Ces grandeurs peuvent par exemple comporter le courant dans la batterie, la tension aux bornes de celle-ci et la température de celle-ci ou de différents éléments la constituant.

Dans les applications envisagées, la batterie est par exemple une batterie au Nickel-Métal Hybride (Ni-MH), ce type de batteries ayant un comportement bien différent des batteries classiques au plomb.

De façon générale, sur un véhicule d'un des types mentionnés précédemment, le courant consommé sur la batterie par la chaîne de traction n'est pas constant et dépend entièrement des consignes du conducteur du véhicule, l'énergie demandée par la machine de traction étant alors éminemment variable suivant les sollicitations de celui-ci.

La détermination de l'état de charge mise en oeuvre dans l'état de la technique consiste en fait à mesurer le courant de la batterie à l'aide d'un capteur de courant correspondant et à cumuler les courants de décharge et de charge de la batterie dans le temps.

US 6 285 163 B1 divulgue un dispositif pour estimer l'état de charge d'une batterie.

US 4 390 841 décrit la surveillance d'une batterie pour indiquer l'énergie qui peut être délivrée à une automobile électrique.

On conçoit cependant qu'un tel procédé présente un certain nombre de limitations et d'imprécisions.

En effet, ce procédé doit être initialisé correctement au départ, et dérive plus ou moins rapidement suivant les caractéristiques du capteur et du calculateur associé à celui-ci.

Le recalage de ce calculateur peut alors être réalisé au moyen d'une charge de recalage, ce qui impose de charger la batterie à faible courant pendant quelques dizaines de secondes. Ceci nécessite donc de disposer d'un moyen pour réaliser cette charge et de ne pas avoir besoin de la batterie pendant cette période de temps.

On conçoit alors que ces procédés sont peu pratiques à mettre en oeuvre de façon industrielle.

Le but de l'invention est donc de résoudre ces problèmes.

A cet effet, l'invention a pour objet un système de détermination de l'état de charge d'une batterie de stockage d'énergie électrique, notamment pour véhicule automobile, caractérisé en ce qu'il comporte des moyens de mesure du courant dans la batterie, raccordés à des moyens d'intégration pour délivrer une information d'état de charge de celle-ci et associés à une boucle de recalage comportant des moyens de modélisation du fonctionnement de la batterie pour délivrer à partir de l'information d'état de charge, une tension de batterie estimée, des moyens de comparaison de cette tension estimée à une tension mesurée aux bornes de la batterie pour délivrer une information d'écart de tension, et des moyens de traitement de cet écart de tension pour déterminer un courant de correction à appliquer au courant mesuré appliqué aux moyens d'intégration afin de recaler la détermination de l'état de charge.

Selon d'autres caractéristiques :
- les moyens de traitement sont adaptés pour délivrer un courant de correction négatif si la tension estimée est plus grande que la tension mesurée ;
- les moyens de traitement sont adaptés pour délivrer un courant de correction positif si la tension estimée est plus petite que la tension mesurée ;
- les moyens de traitement comprennent des moyens à seuil pour n'appliquer un courant de correction que si l'écart de tension dépasse un premier seuil prédéterminé ;
- les moyens de traitement comprennent des moyens d'amplification ;
- les moyens d'amplification sont non linéaires.

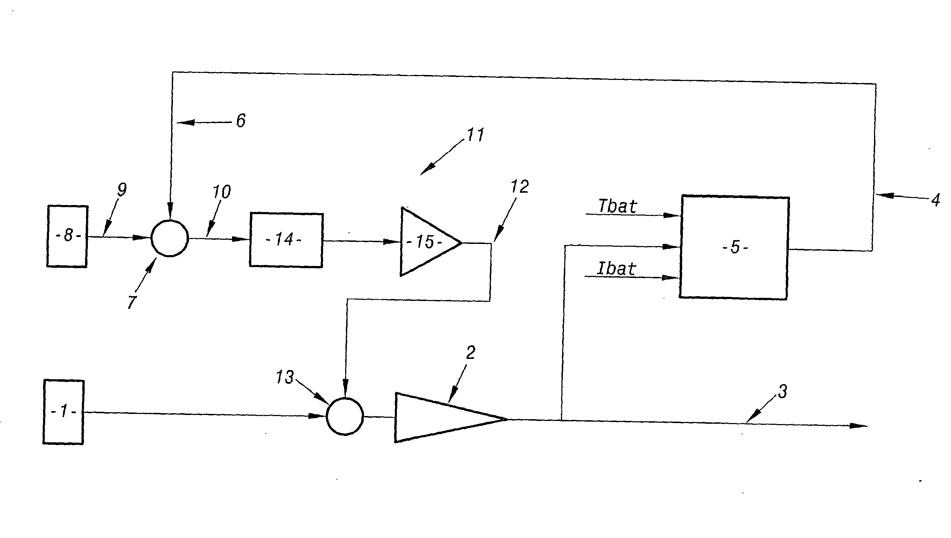

L'invention sera mieux comprise à la lecture de la description qui va suivre, donnée uniquement à titre d'exemple et faite en se référant au dessin annexé qui représente un schéma synoptique illustrant la structure générale et le fonctionnement d'un système de détermination de l'état de charge d'une batterie selon l'invention.

On a en effet représenté sur cette figure, un système de détermination de l'état de charge d'une batterie de stockage d'énergie électrique notamment pour véhicule automobile.

Ce système comporte des moyens de mesure de courant dans la batterie désignés par la référence générale 1 et comportant tout capteur approprié, raccordés à des moyens d'intégration 2 pour délivrer une information d'état de charge de celle-ci. L'information d'état de charge est en effet délivrée en 3 en sortie de ces moyens d'intégration.

Ces moyens d'intégration sont également associés à une boucle de recalage désignée par la référence générale 4, comportant des moyens 5 de modélisation du fonctionnement de la batterie pour délivrer à partir de l'information d'état de charge issue des moyens d'intégration 2, une tension de batterie estimée en 6, à des moyens 7 de comparaison de cette tension estimée à une tension mesurée aux bornes de la batterie grâce à un capteur correspondant 8, la tension mesurée par ce capteur 8 étant délivrée en 9 à ces moyens de comparaison 7.

Ces moyens de comparaison 7 sont alors adaptés pour délivrer une information d'écart de tension en 10, à des moyens de traitement de celui-ci, désignés par la référence générale 11, pour déterminer un courant de correction en 12, à appliquer au courant mesuré par le capteur 1, appliqué aux moyens d'intégration 2, afin de recaler la détermination de l'état de charge.

Un additionneur 13 est alors connecté en entrée des moyens d'intégration 2 et reçoit d'une part, le courant mesuré sur la batterie et d'autre part, le courant de correction à appliquer à celui-ci.

En fait, ces moyens de traitement 11 sont adaptés pour délivrer un courant de correction négatif si la tension estimée est plus grande que la tension mesurée et un courant de correction positif si la tension estimée est plus petite que la tension mesurée.

Les moyens de traitement 11 peuvent par exemple comporter des moyens à seuil désignés par la référence générale 14, pour n'appliquer un courant de correction que si l'écart de tension dépasse un premier seuil prédéterminé.

Ces moyens de traitement peuvent également être associés à des moyens d'émission d'un signal d'alerte dans le cas où l'écart de tension dépasse un second seuil prédéterminé.

Ces moyens de traitement comprennent également des moyens d'amplification désignés par la référence générale 15, qui peuvent par exemple se présenter sous la forme de moyens d'amplification non linéaires.

Les moyens de modélisation du fonctionnement de la batterie désignés par la référence générale 5 sur cette figure, peuvent également recevoir en entrée, des informations de courant dans la batterie et de température de celle-ci, respectivement I bat et T bat.

Bien entendu, la complexité de ces moyens de modélisation dépend des capacités du calculateur de mise en oeuvre disponible et de la précision souhaitée.

Ces moyens peuvent alors recevoir en entrée des informations relatives à un nombre plus ou moins important de grandeurs physiques à-intégrer dans la modélisation

On conçoit alors que ce système permet de déterminer l'état de charge de la batterie en combinant une méthode ampèrométrique classique avec un modèle interne.

Ce modèle a comme entrée l'état de charge de la batterie, le courant de batterie et la température de celle-ci et comme sortie une estimation de la tension batterie.

Cette tension estimée est comparée à la tension mesurée sur la batterie.

Suivant le signe de la différence entre ces deux tensions, on effectue une correction négative ou positive sur le courant de la batterie qui sert à calculer l'état de charge.

Dans le cas où la tension estimée est plus grande que la tension mesurée, cela signifie que l'état de charge est surestimé et qu'il convient alors d'effectuer une correction négative sur celui-ci.

Dans ce cas, le courant de correction sera négatif et l'état de charge calculé avec un courant plus faible aura donc tendance à diminuer.

Dans le cas où la tension estimée est plus petite que la tension mesurée, cela signifie que l'on a sous-estimé l'état de charge.

Il faut donc augmenter le courant d'une valeur positive. Le courant de correction prend alors une valeur positive proportionnelle à l'écart de tension et l'état de charge aura alors tendance à augmenter pour faire diminuer la différence entre la tension estimée et la tension mesurée.

On conçoit alors qu'un recalage se fait en permanence sans nécessiter de phases de recalage particulières.

Une dérive soudaine du système peut également être facilement détectée.

Par ailleurs, il n'est pas non plus nécessaire d'initialiser très précisément ce système dans la mesure où le recalage automatique a lieu en permanence.

Ceci présente un certain nombre d'avantages, notamment en fin de ligne de production, car il n'impose pas un passage au banc des batteries.

Une initialisation à une valeur par défaut compatible avec les contraintes de fonctionnement du véhicule est suffisante.

Pour améliorer le système, on peut intégrer les moyens à seuil permettant de n'appliquer une correction au courant que si la différence entre la tension mesurée et la tension estimée est supérieure à un seuil prédéterminé.

D'autres améliorations du système peuvent consister en l'utilisation des moyens d'amplification non linéaires et l'ajout de moyens d'émission d'un signal d'alerte permettant de savoir si la tension mesurée diffère significativement de la tension estimée, ce qui est le signe d'une mauvaise estimation de l'état de charge.

Comme cela a été indiqué précédemment, les moyens de modélisation de la batterie peuvent être plus ou moins complexes en fonction du type de batterie, des performances du calculateur et du temps de calcul dont on dispose.

On peut par exemple décider d'inclure ou non dans ce modèle, l'influence de la température, de la polarisation, de la relaxation, du vieillissement de la batterie ou tout autre phénomène.

Un exemple de mise en oeuvre de ce système a été réalisé en utilisant le calculateur de surveillance de la batterie dans un véhicule hybride parallèle.

On conçoit alors qu'un tel système peut être appliqué sur tout véhicule utilisant une batterie et possédant les différents capteurs nécessaires, c'est-à-dire en fait un capteur de courant de batterie, un capteur de tension de batterie, des moyens de mesure de la température de celle-ci ou d'éléments constitutifs de celle-ci et des moyens permettant de construire un modèle de fonctionnement de la batterie.

Ce système permet une estimation précise de l'état de charge et donc une meilleure gestion de l'énergie électrique disponible à bord du véhicule, ce qui se traduit par une meilleure gestion de la consommation de carburant.

Ce système permet également de prolonger la durée de vie de la batterie.

## Revendications

1. Système de détermination de l'état de charge d'une batterie de stockage d'énergie électrique, notamment pour véhicule automobile, comportant des moyens (1) de mesure du courant dans la batterie, raccordés à des moyens d'intégration (2) pour délivrer une information d'état de charge de celle-ci et associés à une boucle de recalage (4) comportant des moyens de modélisation (5) du fonctionnement de la batterie pour délivrer à partir de l'information d'état de charge, une tension de batterie estimée, des moyens (7) de comparaison de cette tension estimée à une tension mesurée aux bornes de la batterie pour délivrer une information d'écart de tension, et des moyens de traitement (11) de cet écart de tension, **caractérisé en ce que** les moyens de traitement (11) sont aptes à déterminer un courant de correction à appliquer au courant mesuré appliqué aux moyens d'intégration (2) afin de recaler l'état de charge.

2. Système selon la revendication 1, **caractérisé en ce que** les moyens de traitement (11) sont adaptés pour délivrer un courant de correction négatif si la tension estimée est plus grande que la tension mesurée.

3. Système selon la revendication 1, **caractérisé en ce que** les moyens de traitement (11) sont adaptés pour délivrer un courant de correction positif si la tension estimée est plus petite que la tension mesurée.

4. Système selon l'une quelconque des revendications précédentes, **caractérisé en ce que** les moyens de traitement (11) comprennent des moyens à seuil (14) pour n'appliquer un courant de correction que si l'écart de tension dépasse un premier seuil prédéterminé.

5. Système selon l'une quelconque des revendications précédentes, **caractérisé en ce que** les moyens de traitement (11) comprennent des moyens d'amplification (15).

6. Système selon la revendication 5, **caractérisé en ce que** les moyens d'amplification (15) sont non linéaires.

## Claims

1. System for determining the state of charge of a battery for storing electrical energy, in particular for an automobile vehicle, comprising means (1) for measuring current in the battery, connected to integration means (2) to deliver information concerning the state of charge thereof and associated with a resetting loop (4) comprising modelling means (5) of the functioning of the battery to deliver, from the information concerning the state of charge, an estimated battery voltage, comparison means (7) of this estimated voltage to a voltage measured at the terminals of the battery to deliver information of voltage deviation, and processing means (11) of this voltage deviation, **characterized in that** the processing means (11) are suited to determine a correction current to be applied to the measured current applied to the integration means (2) so as to reset the state of charge.

2. System according to Claim 1, **characterized in that** the processing means (11) are adapted to deliver a negative correction current if the estimated voltage is greater than the measured voltage.

3. System according to Claim 1, **characterized in that** the processing means (11) are adapted to deliver a positive correction current if the estimated voltage is lower than the measured voltage.

4. System according to any one of the preceding claims, **characterized in that** the processing means (11) comprise threshold means (14), so as to only apply a correction current if the voltage deviation exceeds a predetermined first threshold.

5. System according to any one of the preceding claims, **characterized in that** the processing means (11) comprise amplification means (15).

6. System according to Claim 5, **characterized in that** the amplification means (15) are non-linear.

## Patentansprüche

1. System zum Bestimmen des Ladezustands eines Speicherakkus für elektrische Energie, insbesondere für Kraftfahrzeug, das Mittel (1) zum Messen des Stroms in dem Akku aufweist, die an Integrationsmittel (2) angeschlossen sind, um seine Ladezustandsinformation zu liefern, und mit einer Einstellschleife (4) verbunden sind, die Mittel (5) zum Modellieren des Funktionierens des Akkus aufweisen, um ausgehend von der Ladezustandsinformation eine geschätzte Akkuspannung zu liefern, Mittel (7) zum Vergleichen dieser geschätzten Spannung mit einer an den Klemmen des Akkus gemessenen Spannung, um eine Spannungsunterschiedinformation zu liefern, und Mittel (11) zum Verarbeiten dieses Spannungsunterschieds, **dadurch gekennzeichnet, dass** die Verarbeitungsmittel (11) einen Korrekturstrom bestimmen können, der an den gemessenen Strom, der an die Integrationsmittel (2) angelegt wird, anzuwenden ist, um den Ladezustand einzustellen.

2. System nach Anspruch 1, **dadurch gekennzeichnet, dass** die Verarbeitungsmittel (11) einen negativen Korrekturstrom liefern können, wenn die geschätzte Spannung größer ist als die gemessenen Spannung.

3. System nach Anspruch 1, **dadurch gekennzeichnet, dass** die Verarbeitungsmittel (11) einen positiven Korrekturstrom liefern können, wenn die geschätzte Spannung kleiner ist als die gemessene Spannung.

4. System nach einem der vorhergehenden Ansprüche, **dadurch gekennzeichnet, dass** die Verarbeitungsmittel (11) Mittel mit Schwellenwert (14) aufweisen, um einen Korrekturstrom nur anzulegen, wenn der Spannungsunterschied einen ersten vorbestimmten Schwellenwert überschreitet.

5. System nach einem der vorhergehenden Ansprüche, **dadurch gekennzeichnet, dass** die Verarbeitungsmittel (11) Verstärkungsmittel (15) aufweisen.

6. System nach Anspruch 5, **dadurch gekennzeichnet, dass** die Verstärkungsmittel (15) nicht linear sind.
